# EUROPEAN PATENT SPECIFICATION

(11) **EP 1 364 414 B1**
(45) Date of publication and mention of the grant of the patent: **10.12.2008**
(21) Application number: 01912641.6
(22) Date of filing: 30.01.2001
(51) Int. Cl.: H01L 31/12, H01L 27/15

(54) **A LEAD FRAME FOR AN OPTO-COUPLER**
ANSCHLUSSKAMM FÜR EINEN OPTOKOPPLER
CADRE DE MONTAGE POUR OPTO-COUPLEUR

(43) Date of publication of application: 26.11.2003
(73) Proprietor: Infineon Technologies AG, 81669 München (DE)
(72) Inventor: LOW, Tek, Beng, 75150 Melaka (MY); CHUA, Chee Seong, 75050 Melaka (MY)
(74) Representative: Howe, Steven
(86) International application number: PCT/SG2001/000013
(87) International publication number: WO 2002/061853

(56) References cited:
- JP-A- 8 167 687
- JP-A- 8 250 762
- JP-A- 9 298 309
- US-A- 4 446 375
- US-A- 5 489 800
- US-A- 5 753 929
- US-A- 6 031 251
- DATABASE WPI Derwent Publications Ltd., London, GB; AN 1995-372224, XP002970601 & JP 7 254 728 A (SHARP KK) 03 October 1995
- DATABASE WPI Derwent Publications Ltd., London, GB; AN 1995-326374, XP002970602 & JP 7 226 533 A (NEC CORP) 22 August 1995

## Description

The invention relates to a lead frame for an opto-coupler and a method of manufacturing an opto-coupler.

Generally, there are two different designs that are commonly used to manufacture opto-couplers. These are:
(i) the over-under design; and
(ii) the coplanar design.

(i) In the "over-under" design concept, separate lead frames are used to the emitter and the detector. The emitter and detector lead-frames are then positioned with one above the other and coupled together. As a result, the emitter and detector are "over-under" each other and the gap between the emitter and the detector provides the electrical isolation. An inner translucent material is then moulded around the emitter and detector to provide the optical coupling between the emitter and the detector. Subsequently, a dark outer moulding is used to encapsulate and protect the whole package. One of the main advantages of this design is the good electrical isolation provided by the gap between the emitter and the detector. However the "over-under" coupling process itself hinders manufacturing flexibility as it involves processing and greater care is required during the coupling process.
   JP 7226533 shows an example of a photocoupler in which a light emitting element is mounted on an input side lead frame and a light receiving element is mounted on an output side lead frame. A transparent resin film is formed at the tip of the output side lead frame to cover the end portions of the lead frame and light receiving element. Transparent resin is also provided to fill the space between the light emitting element and light receiving element to define an optical path between the elements. The whole body is packaged with mould resin.
(ii) In the coplanar design, both the emitter and detector chips are bonded on the same plane. These are then encased in a "blob" of translucent resin in order to provide the optical coupling. The whole structure is then encapsulated to protect the package from the environment. This design has the advantage that it is easier to manufacture compared to the "over-under" design, as the manufacturing process is simplified due to its similarity to current conventional back-end processes. However, a major weakness of this design is the lower electrical isolation capability. This is due to the use of a "blob" of moulding material to surround the emitter and detector, as this limits the physical separation (and therefore, electrical isolation) of the emitter and detector.

In accordance with a first aspect of the present invention as defined in claim 1, a lead frame for manufacturing an opto-coupler comprises an emitter portion, a detector portion, a first contact portion and a second contact portion, each of the portions being adjacent to but spaced from each of the other portions; and a mould moulded onto the portions encircling the portions and extending below the portions, the mould defining a cavity across the upper surface of the portions, and the mould cavity being an electrically insulating moulding material.

In accordance with a second aspect of the present invention as defined in claim 5, a method of manufacturing an opto-coupler comprises providing a lead frame in accordance with the first aspect of the invention, attaching an optical radiation emitter device to the emitter portion, attaching an optical radiation detection device to the detector portion, bonding a first electrically conducting wire between a contact surface on the emitter device and the first contact portion, bonding a second electrically conducting wire between a contact surface on the detector device and the second contact portion; introducing a first moulding material into the mould cavity and curing the moulding material, the first moulding material transmitting optical radiation when cured; and covering the exposed surface of the first moulding material with a second moulding material that is opaque when cured.

In accordance with a third aspect of the invention, there is provided a method of manufacturing an opto-coupler including providing a lead frame comprising an emitter portion, a detector portion, a first contact portion and a second contact portion, each of the portions being adjacent to but spaced from each of the other portions; and moulding a mould onto the portions, encircling the portions and extending below the portions, the mould defining a cavity across the upper surface of the portions, and the mould being moulded from an electrically insulating material.

The term "optical radiation" as used herein means radiation in the ultra-violet, visible or infrared regions of the electro-magnetic spectrum.

Preferably, the portions on the lead frame are coplanar with each other.

Preferably, the mould is formed on the lead frame by a moulding process, such as an injection moulding process.

Typically, the mould is formed from material that has a light colour, and preferably, is substantially white when cured.

Preferably, the second moulding material has a light colour, and preferably, is substantially white when cured.

Preferably, the method further comprises, after permitting the second moulding material to cure, encapsulating the mould cavity and the second moulding material in the third moulding material.

An example of a lead frame for an opto-coupler and a method of manufacturing an opto-coupler in accordance with the invention will now be described with reference to the accompanying drawings, in which:
Figure 1 is a plan view of a lead frame having an opto-coupler formed thereon, prior to singulation;
Figure 2 is a cross-sectional view of the opto-coupler of Figure 1 along the line A-A; and
Figure 3 is a cross-sectional view of the opto-coupler along the line B-B.

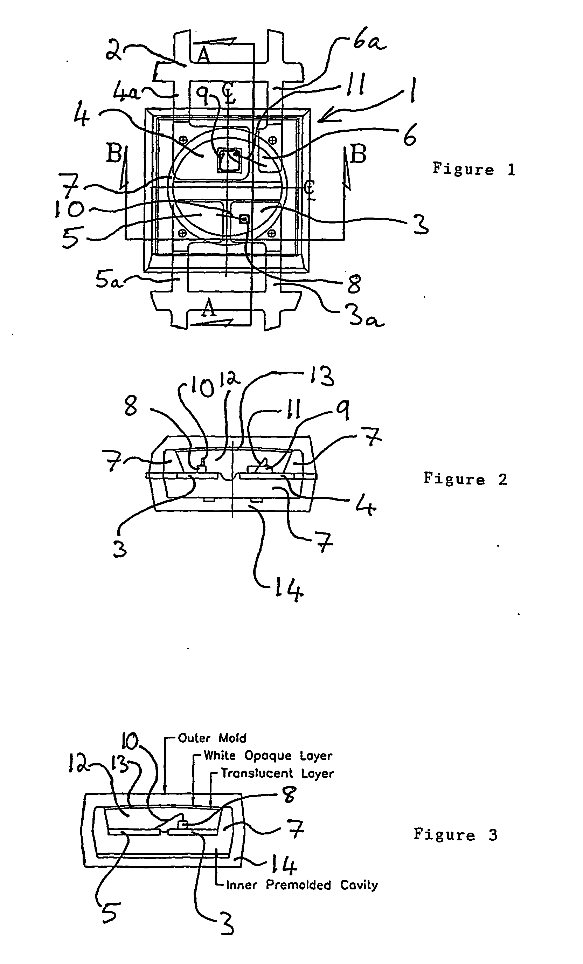

Figure 1 is a plan view of an opto-coupler 1 manufactured on a lead frame 2.
Figure 1 shows only a portion of the lead frame 2. Typically, the lead frame 2 would be a straight lead frame or a matrix lead frame that would have a number of opto-couplers 1 manufactured on it. The opto-couplers 1 would then be separated from each other in a process known as "singulation". The lead frame 2 includes, for each opto-coupler 1, an emitter portion 3, a detector portion 4, an emitter contact portion 5 and a detector contact portion 6. Each of the portions 3-6 are encircled by a moulded body 7, which also electronically insulates each of the portions 3-6 from each other, as shown in Figures 2 and 3.

During manufacturing, the lead frame 2 is supplied with the mould body 7 pre-moulded onto the lead frame 2. For example, the mould body 7 may be pre-moulded onto the lead frame 2 by a conventional injection moulding process. In addition, preferably, the mould body 7 is formed from a white moulding material.

It will also be noted that the mould body 7 extends below the portions 3-6 but does not extend across the upper surfaces of the portions 3-6.

To manufacture the opto-coupler 1, the lead frame 2 with the pre-moulded body 7 is taken and an emitter 8 is attached to the emitter portion 3 and a detector 9 is attached to the detector portion 4. A wire bond 10 is then formed between the emitter 8 and the emitter contact portion 5, and another wire bond 11 formed between the detector 9 and the detector contact portion 6.

After the wire bonds 10, 11 have been formed, the mould is filled with a translucent mould material 12 which covers the top surfaces of the portions 3-6, the emitter 8, the detector 9, and the wire bonds 11, 12. After the translucent moulding material 12 has cured, an opaque white layer 13 of moulding material is applied over the exposed surface of the translucent mould material 12. After the layer 13 has cured, the mould body 7 and the white opaque layer 13 are encapsulated in an outer protective moulding material 14.

After singulation, the only sections of the lead frame 2 extending from the outer mould material 14 are sections 3a, 4a, 5a, 6a of the lead frame 2 which form the electrical contact pins for the opto-coupler 1.

Advantages of the invention are that it does not have the handling problems associated with the "over under" design, and by providing a pre-formed mould body 7 on the lead frame 2, it is possible to manufacture an opto-coupler 1 with electrical isolation between the portions 3-6 which is greater than for conventional coplanar designs.

Furthermore, there is an advantage that manufacturing of the opto-coupler 1 can be performed using the "reel to reel" process. This has the advantage of enhancing manufacturing efficiency and reducing time loss due to operator handling.

## Claims

1. A pre-moulded lead frame (2) as an intermediate product for manufacturing an opto-coupler (1), comprising an emitter portion (3) for the subsequent attaching of an emitter device (8), a detector portion (4) for the subsequent attaching of a detector device (9), a first contact portion (5) and a second contact portion (6), each of the portions (3-6) being adjacent to but spaced from each of the other portions (3-6); and further comprising a mould (7) moulded onto the portions (3-6), encircling the portions (3-6) and extending below the portions (3-6), the mould (7) defining a cavity across the upper surface of the portions, and the mould (7) being an electrically insulating moulding material.

2. A lead frame according to claim 1, wherein the portions (3-6) on the lead frame (2) are coplanar with each other.

3. A lead frame according to claim 1 or claim 2, wherein the mould (7) comprises an injection moulding material on the lead frame (2).

4. A lead frame according to any of the preceding claims, wherein the mould (7) is formed from a material that is white.

5. A method of manufacturing an opto-coupler (1), the method comprising providing a pre-moulded lead frame (2) as an intermediate product for manufacturing an opto-coupler (1) comprising an emitter portion (3) for the subsequent attaching of an emitter device (8), a detector portion (4) for the subsequent attaching of a detector device (9), a first contact portion (5) and a second contact portion (6), each of the portions (3-6) being adjacent to but spaced from each of the other portions (3-6); and further comprising a mould (7) moulded onto the portions (3-6), encircling the portions (3-6) and extending below the portions (3-6), the mould (7) defining a cavity across the upper surface of the portions, and the mould (7) being moulded from an electrically insulating material.

6. A method according to claim 5, wherein the portions (3-6) on the lead frame (2) are coplanar with each other.

7. A method according to claim 5 or claim 6, wherein the mould (7) is formed on the lead frame by a moulding process, such as an injection moulding process.

8. A method according to any one of claims 5, 6 or 7, wherein the mould (7) is formed from a material that is white.

9. A method of manufacturing an opto-coupler according to any one of claims 5 to 8, comprising: attaching an optical radiation emitter device (8) to said emitter portion (3), attaching an optical radiation detection device (9) to said detector portion (4), bonding a first electrically conducting wire (10) between a contact surface on the emitter device (8) and the first contact portion (5), bonding a second electrically conducting wire (11) between a contact surface on the detector device (9) and the second contact portion (6); introducing a first moulding material (12) into the cavity and curing the first moulding material (12), the first moulding material (12) transmitting optical radiation when cured; and covering the exposed surface of the first moulding material (12) with a second moulding material (13) that is opaque when cured.

10. A method according to claim 9, wherein the second moulding material (13) is white when cured.

11. A method according to claim 9 or claim 10, further comprising, after permitting the second moulding material (13) to cure, encapsulating the mould (7) and the second moulding material (13) in a third moulding material (14).

## Patentansprüche

1. Vorgeformter Anschlußkamm (2) als Zwischenprodukt für die Herstellung eines Optokopplers (1), der einen Emitterabschnitt (3) zum späteren Anbringen einer Emittervorrichtung (8), einen Detektorabschnitt (4) zum späteren Anbringen einer Detektorvorrichtung (9), einen ersten Kontaktabschnitt (5) und einen zweiten Kontaktabschnitt (6) aufweist, wobei jeder der Abschnitte (3-6) jedem der anderen Abschnitte (3-6) benachbart, aber davon beabstandet ist; und der ferner ein auf die Abschnitte (3-6) aufgebrachtes Formstück (7) aufweist, das die Abschnitte (3-6) umgibt und sich unter den Abschnitten (3-6) erstreckt, wobei das Formstück (7) einen Hohlraum über die Oberseiten der Abschnitte definiert, und wobei das Formstück (7) eine elektrisch isolierende Formmasse ist.

2. Anschlußkamm nach Anspruch 1, wobei die Abschnitte (3-6) auf dem Anschlußkamm (2) koplanar zueinander sind.

3. Anschlußkamm nach Anspruch 1 oder Anspruch 2, wobei das Formstück (7) ein Spritzgußmaterial auf dem Anschlußkamm (2) aufweist.

4. Anschlußkamm nach einem der vorstehenden Ansprüche, wobei das Formstück (7) aus einem weißen Material geformt wird.

5. Verfahren zur Herstellung eines Optokopplers (1), wobei das Verfahren die Bereitstellung eines vorgeformten Anschlußkamms (2) als Zwischenprodukt für die Herstellung eines Optokopplers (1) aufweist, der einen Emitterabschnitt (3) zum späteren Anbringen einer Emittervorrichtung (8), einen Detektorabschnitt (4) zum späteren Anschließen einer Detektorvorrichtung (9), einen ersten Kontaktabschnitt (5) und einen zweiten Kontaktabschnitt (6) aufweist, wobei jeder der Abschnitte (3-6) jedem der anderen Abschnitte (3-6) benachbart, aber davon beabstandet ist; und der ferner ein auf die Abschnitte (3-6) aufgebrachtes Formstück (7) aufweist, das die Abschnitte (3-6) umgibt und sich unter den Abschnitten (3-6) erstreckt, wobei das Formstück (7) einen Hohlraum über die Oberseiten der Abschnitte definiert, und wobei das Formstück (7) aus einem elektrisch isolierenden Material geformt wird.

6. Verfahren nach Anspruch 5, wobei die Abschnitte (3-6) auf dem Anschlußkamm (2) koplanar zueinander sind.

7. Verfahren nach Anspruch 5 oder Anspruch 6, wobei das Formstück (7) auf dem Anschlußkamm durch ein Formgebungsverfahren, wie z. B. ein Spritzgießverfahren, geformt wird.

8. Verfahren nach einem der Ansprüche 5, 6 oder 7, wobei das Formstück (7) aus einem weißen Material geformt wird.

9. Verfahren zur Herstellung eines Optokopplers nach einem der Ansprüche 5 bis 8, das aufweist: Anbringen einer optischen Strahlungsemittervorrichtung (8) an den Emitterabschnitt (3), Anbringen einer optischen Strahlungsdetektorvorrichtung (9) an den Detektorabschnitt (4), Bonden eines ersten elektrisch leitenden Drahts (10) zwischen einer Kontaktfläche an der Emittervorrichtung (8) und dem ersten Kontaktabschnitt (5), Bonden eines zweiten elektrisch leitenden Drahts (11) zwischen einer Kontaktfläche an der Detektorvorrichtung (9) und dem zweiten Kontaktabschnitt (6); Einbringen einer ersten Formmasse (12) in den Hohlraum und Aushärten der ersten Formmasse (12), wobei die erste Formmasse (12) im ausgehärteten Zustand optische Strahlung durchläßt; und Abdecken der freiliegenden Oberfläche der ersten Formmasse (12) mit einer zweiten Formmasse (13), die im ausgehärteten Zustand opak ist.

10. Verfahren nach Anspruch 9, wobei die zweite Formmasse (13) im ausgehärteten Zustand weiß ist.

11. Verfahren nach Anspruch 9 oder Anspruch 10, das ferner nach dem Aushärtenlassen der zweiten Formmasse (13) die Kapselung des Formstücks (7) und der zweiten Formmasse (13) in einer dritten Formmasse (14) aufweist.

## Revendications

1. Grille de connexion (2) moulée à l'avance utilisée comme produit intermédiaire pour fabriquer un opto coupleur (1), comprenant une partie d'émetteur (3) pour la fixation ultérieure d'un composant émetteur (8), une partie de détecteur (4) pour la fixation ultérieure d'un composant détecteur (9), une première partie de contact (5) et une seconde partie de contact (6), chacune des parties (3 à 6) étant contiguë mais espacée de chacune des autres parties (3 à 6) ; et comprenant également un moule (7) qui est moulé sur les parties (3 à 6), encerclant les parties (3 à 6) et s'étendant en dessous des parties (3 à 6), le moule (7) définissant une cavité de part et d'autre de la surface supérieure des parties, et le moule (7) étant constitué d'un matériau de moulage électriquement isolant.

2. Grille de connexion selon la revendication 1, dans laquelle les parties (3 à 6) sur la grille de connexion (2) sont coplanaires.

3. Grille de connexion selon la revendication 1 ou la revendication 2, dans laquelle le moule (7) comprend un matériau de moulage par injection sur la grille de connexion (2).

4. Grille de connexion selon l'une quelconque des revendications précédentes, dans laquelle le moule (7) est formé à partir d'un matériau qui est blanc.

5. Procédé de fabrication d'un opto coupleur (1), le procédé comprenant la fourniture d'une grille de connexion (2) moulée à l'avance en tant que produit intermédiaire pour fabriquer un opto coupleur (1) comprenant une partie d'émetteur (3) destinée à la fixation ultérieure d'un composant émetteur (8), une partie de détecteur (4) destinée à la fixation ultérieure d'un composant détecteur (9), une première partie de contact (5) et une seconde partie de contact (6), chacune des parties (3 à 6) étant contiguë mais espacée de chacune des autres parties (3 à 6) ; et comprenant en outre un moule (7) qui est moulé sur les parties (3 à 6), encerclant les parties (3 à 6) et s'étendant en dessous des parties (3 à 6), le moule (7) définissant une cavité de part et d'autre de la surface supérieure des parties, et le moule (7) étant moulé à partir d'un matériau électriquement isolant.

6. Procédé selon la revendication 5, dans lequel les parties (3 à 6) sur la grille de connexion (2) sont coplanaires.

7. Procédé selon la revendication 5 ou la revendication 6, dans lequel le moule (7) est formé sur la grille de connexion grâce à un processus de moulage, tel qu'un processus de moulage par injection.

8. Procédé selon l'une quelconque des revendications 5, 6 ou 7, dans lequel le moule (7) est formé à partir d'un matériau qui est blanc.

9. Procédé de fabrication d'un opto coupleur selon l'une quelconque des revendications 5 à 8, comprenant : la fixation d'un composant émetteur de rayonnements optiques (8) sur ladite partie d'émetteur (3), la fixation d'un composant de détection de rayonnements optiques (9) sur ladite partie de détecteur (4), la soudure d'un premier fil électriquement conducteur (10) entre une surface de contact disposée sur le composant émetteur (8) et la première partie de contact (5), la soudure d'un second fil électriquement conducteur (11) entre une surface de contact disposée sur le dispositif détecteur (9) et la seconde partie de contact (6) ; l'introduction d'un premier matériau de moulage (12) dans la cavité et la cuisson du premier matériau de moulage (12), le premier matériau de moulage (12) transmettant des rayonnements optiques lorsqu'il est cuit ; ainsi que la couverture de la surface exposée du premier matériau de moulage (12) avec un second matériau de moulage (13) qui est opaque lorsqu'il est cuit.

10. Procédé selon la revendication 9, dans lequel le second matériau de moulage (13) est blanc lorsqu'il est cuit.

11. Procédé selon la revendication 9 ou la revendication 10, comprenant en outre, après avoir autorisé la cuisson du second matériau de moulage (13), l'encapsulage du moule (7) et du second matériau de moulage (13) dans un troisième matériau de moulage (14).
